# FASCICULE DE BREVET EUROPEEN

(11) **EP 4 406 004 B1**
(45) Date de publication et mention de la délivrance du brevet: **30.07.2025**
(21) Numéro de dépôt: 22789252.8
(22) Date de dépôt: 06.09.2022
(51) Int. Cl.: H01L 21/02, H01L 21/18, H01L 21/762

(54) **PROCEDE DE FABRICATION D'UN SUBSTRAT SUPPORT EN CARBURE DE SILICIUM POLY-CRISTALLIN**
VERFAHREN ZUR HERSTELLUNG EINES POLYKRISTALLINEN SILICIUMCARBIDTRÄGERSUBSTRATS
METHOD FOR FABRICATING A POLYCRYSTALLINE SILICON CARBIDE CARRIER SUBSTRATE

(30) Priorité: 22.09.2021 FR 2109961
(43) Date de publication de la demande: 31.07.2024
(73) Titulaire: SOITEC, 38190 Bernin (FR)
(72) Inventeur: BIARD, Hugo, 38190 Bernin (FR); LAGRANGE, Mélanie, 38190 Bernin (FR)
(74) Mandataire: IP Trust
(86) Numéro de dépôt international: PCT/FR2022/051682
(87) Numéro de publication internationale: WO 2023/047035

(56) Documents cités:
- JP-A- H08 188 408
- US-A- 5 714 395
- US-A1- 2003 129 780
- US-A1- 2019 153 616
- US-A1- 2019 382 918

## Description

### DOMAINE DE L'INVENTION

La présente invention concerne le domaine des matériaux semiconducteurs pour composants microélectroniques. Elle concerne en particulier un procédé de fabrication d'un substrat support en carbure de silicium poly-cristallin, particulièrement adapté à l'élaboration d'une structure composite comprenant une couche mince en carbure de silicium monocristallin disposée sur ledit substrat support.

### ARRIERE PLAN TECHNOLOGIQUE DE L'INVENTION

Le SiC est de plus en plus largement utilisé pour la fabrication de dispositifs de puissance innovants, pour répondre aux besoins de domaines montants de l'électronique, comme notamment les véhicules électriques. En effet, les dispositifs de puissance et les systèmes intégrés d'alimentation basés sur du carbure de silicium monocristallin peuvent gérer une densité de puissance beaucoup plus élevée par rapport à leurs homologues traditionnels en silicium, et ce avec des dimensions de zone active inférieures.

Les substrats en SiC monocristallin (c-SiC) de haute qualité, destinés à l'industrie microélectronique, restent néanmoins chers et difficiles à approvisionner en grande taille. Il est donc avantageux de recourir à des solutions de transfert de couches, pour élaborer des structures composites comprenant typiquement une couche mince en SiC monocristallin (issue du substrat en c-SiC de haute qualité) sur un substrat support plus bas coût, par exemple en SiC poly-cristallin (p-SiC). Une solution de transfert de couche mince bien connue est le procédé Smart Cut^{®}, basé sur une implantation d'ions légers et sur un assemblage, par collage direct, au niveau d'une interface de collage.

Le document US2019153616 propose un procédé de fabrication d'un substrat support en p-SiC sur lequel peut être reportée une couche mince en c-SiC. Le substrat support comprend des grains de taille moyenne de l'ordre de 10µm et présente un taux de variation de la taille de grain entre ses faces avant et arrière, ramené à son épaisseur, inférieur ou égal à 0,43% ; cette dernière caractéristique permet de limiter la contrainte résiduelle dans le substrat support et donc sa courbure.

Le procédé de fabrication implique un premier substrat de base en carbone sur lequel une couche épaisse (typiquement 2mm) en p-SiC est élaborée par dépôt chimique en phase vapeur. Un deuxième substrat de base en p-SiC, d'environ 350µm d'épaisseur, est extrait de la couche épaisse de p-SiC, par retrait du premier substrat de base en carbone et par amincissement mécanique des deux faces de la couche épaisse. Le deuxième substrat de base présente un taux de variation de la taille de grains entre ses faces avant et arrière, ramené à son épaisseur, inférieur ou égal à 0,43%. Une nouvelle couche de p-SiC (typiquement de l'ordre de 400µm) est ensuite formée par dépôt chimique en phase vapeur sur le deuxième substrat de base : séparée du deuxième substrat de base, par exemple par irradiation laser, cette nouvelle couche de p-SiC constitue le substrat support en p-SiC destiné à être utilisé dans une structure composite. Le deuxième substrat de base peut ensuite être réutilisé.

En pratique, l'étape consistant à former le deuxième substrat de base peut s'avérer complexe car le retrait du premier substrat de base en carbone induit généralement une courbure de la couche épaisse en p-SiC très importante, qui peut provoquer la casse de ladite couche épaisse, ou tout au moins qui complique, voire empêche la réalisation de l'étape d'amincissement requise pour atteindre l'épaisseur du deuxième substrat de base. En outre, cet amincissement est très substantiel (de l'ordre de 1,5mm) et couteux en matériau p-SiC et en étapes de dépôt et d'amincissement.

### OBJET DE L'INVENTION

La présente invention propose un procédé de fabrication adressant la problématique précitée. Elle concerne un procédé de fabrication d'un substrat support en SiC poly-cristallin, économique et simplifié. Ledit substrat support est en outre particulièrement adapté à la fabrication d'une structure composite comportant une couche mince en c-SiC disposée sur ledit substrat support en p-SiC.

### BREVE DESCRIPTION DE L'INVENTION

L'invention concerne un procédé de fabrication d'un substrat support en carbure de silicium poly-cristallin comprenant les étapes suivantes :
a) la croissance d'un substrat initial en carbure de silicium poly-cristallin sur un germe en graphite ou en carbure de silicium ; à l'issue de l'étape a), le substrat initial présentant une face avant libre et une face arrière en contact avec le germe,
b) la formation d'un film raidisseur en carbone, sur la face avant du substrat initial, le substrat initial présentant, dans le plan de sa face avant et juste avant la formation du film raidisseur, une première taille moyenne de grains de carbure de silicium,
c) le retrait du germe, de manière à libérer la face arrière du substrat initial, ce dernier présentant, dans le plan de sa face arrière et juste après le retrait du germe, une deuxième taille moyenne de grains de carbure de silicium, inférieure à la première taille moyenne,
d) l'amincissement de la face arrière du substrat initial, jusqu'à une épaisseur pour laquelle le substrat initial présente, dans le plan de sa face arrière amincie, une troisième taille moyenne de grains égale à la première taille moyenne de grains à +/- 30% près, le substrat initial aminci formant le substrat support.

Selon d'autres caractéristiques avantageuses et non limitatives de l'invention, prises seules ou selon toute combinaison techniquement réalisable :
- le film raidisseur présente une épaisseur comprise entre 100nm et plusieurs millimètres, par exemple 10mm ;
- le film raidisseur présente une épaisseur comprise entre 100nm et 10µm ;
- le film raidisseur en carbone présente une structure cristallographique de type diamant ou de type carbone vitreux ;
- l'étape b) est réalisée par étalement d'une résine polymère comportant des liaisons carbone-carbone préformées dans les trois dimensions, sous forme de couche visqueuse, sur la face avant du substrat initial, et par recuit à une température comprise entre 500°C et 2000°C, pour former le film raidisseur en carbone ;
- la résine polymère est à base de goudron de houille, de phénol formaldéhyde, d'alcool polyfurfurylique, d'alcool polyvinylique, de polyacrylonitrile, de chlorure de polyvinylidène, et/ou de polystyrène ;
- l'étape b) est réalisée par dépôt par plasma, dépôt par bombardement d'ions ou dépôt par évaporation ;
- le procédé de fabrication comprend une étape a'), entre l'étape a) et l'étape b), de rectification de la face avant et/ou d'un pourtour du substrat initial, pour diminuer une rugosité de surface de ladite face et/ou une variation d'épaisseur dudit substrat, et/ou pour régulariser son pourtour ;
- l'étape a') comprend un amincissement mécanique ou mécano-chimique ;
- le procédé de fabrication comprend :
   - une étape e), après l'étape d), de retrait du film raidisseur, et/ou
   - une étape, après l'étape d) ou après l'étape e), de traitement thermique à une température supérieure ou égale à 1500°C.

L'invention concerne également un procédé de fabrication d'une structure composite, mettant en œuvre le procédé ci-dessus et comprenant en outre une étape f) de transfert d'une couche mince en carbure de silicium monocristallin sur une première ou sur une deuxième face du substrat support, directement ou via une couche intermédiaire, pour former la structure composite.

Selon d'autres caractéristiques avantageuses et non limitatives de l'invention, prises seules ou selon toute combinaison techniquement réalisable :
- la couche intermédiaire est formée par le film raidisseur en carbone conservé sur la première face du substrat support ;
- le transfert de la couche mince est réalisé sur l'une des faces du substrat support et un film additionnel en carbone est disposé sur l'autre face libre du substrat support préalablement au transfert ;
- le film additionnel est retiré, préférentiellement après que la structure composite ait subi tous traitements thermiques à températures supérieures à 1400°C requis pour sa fabrication ou celle de composants sur et/ou dans ladite structure.

### BREVE DESCRIPTION DES FIGURES

D'autres caractéristiques et avantages de l'invention ressortiront de la description détaillée de l'invention qui va suivre en référence aux figures annexées sur lesquelles :
[Fig. 1a]
[Fig. 1b]
[Fig. 1c]
[Fig. 1d]
[Fig. 1e]

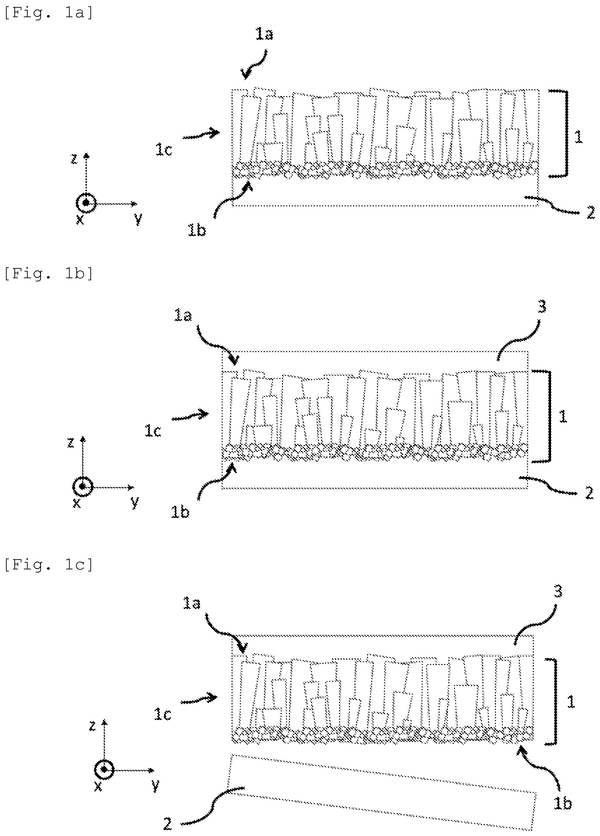

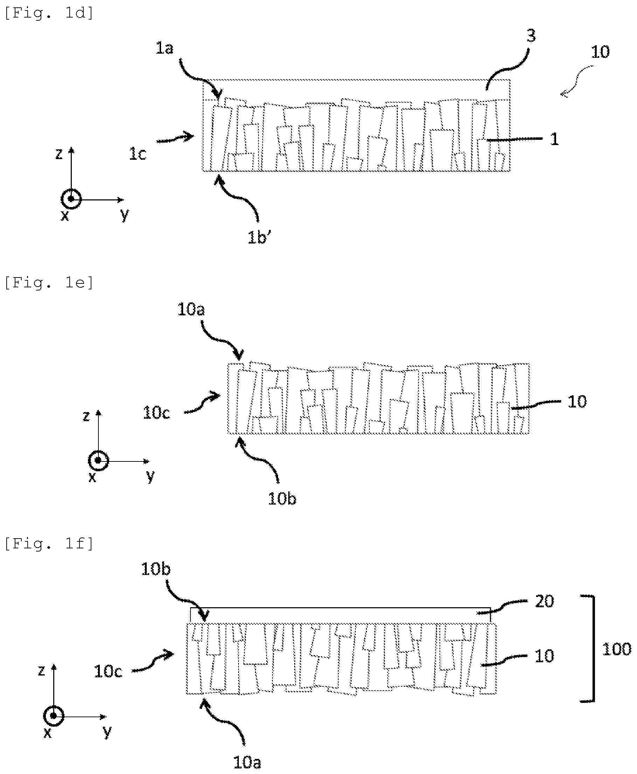

[Fig. 1f] Les figures 1a à 1f présentent des étapes d'un procédé de fabrication conforme à l'invention ;
[Fig. 2a]
[Fig. 2b]
[Fig. 2c]

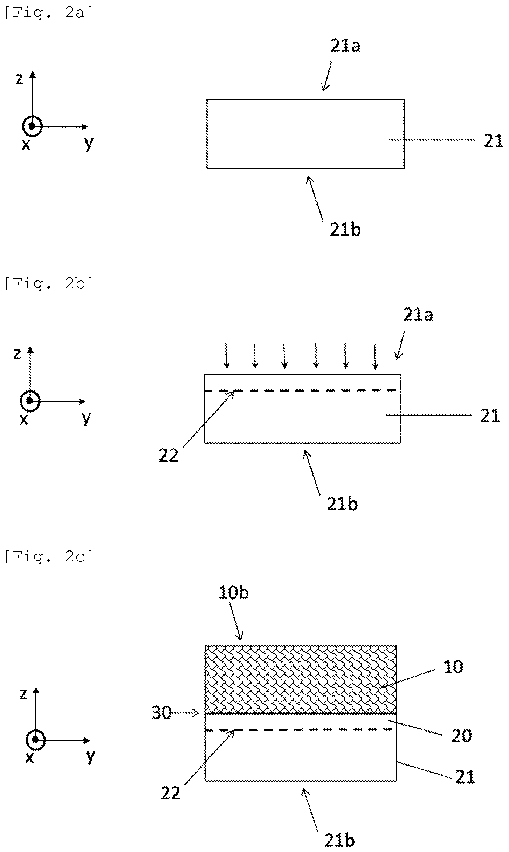

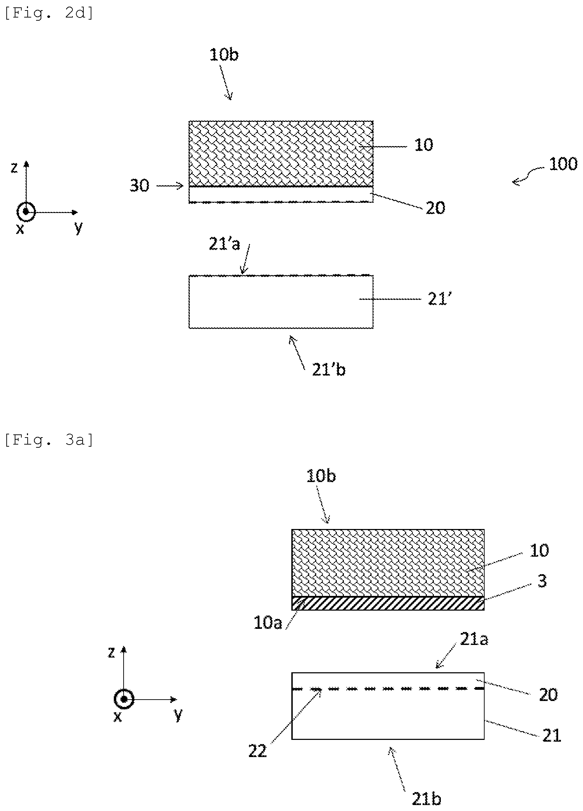

[Fig. 2d] Les figures 2a à 2d présentent d'autres étapes du procédé de fabrication conforme à l'invention ;
[Fig. 3a]
[Fig. 3b]
[Fig. 3c]
[Fig. 3d]

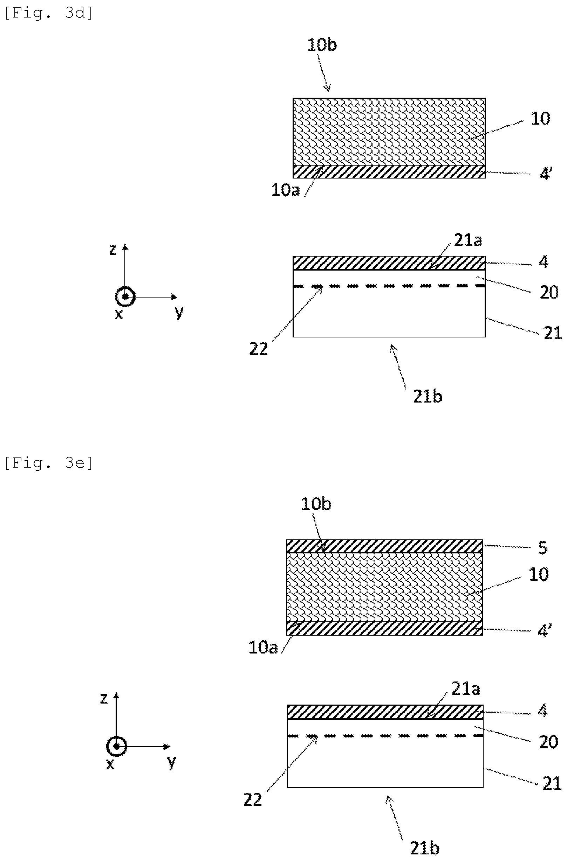

[Fig. 3e] Les figures 3a à 3e présentent des variantes d'étapes du procédé de fabrication conforme à l'invention.

Les mêmes références sur les figures pourront être utilisées pour des éléments de même type. Les figures sont des représentations schématiques qui, dans un objectif de lisibilité, ne sont pas à l'échelle. En particulier, les épaisseurs des couches selon l'axe z ne sont pas à l'échelle par rapport aux dimensions latérales selon les axes x et y ; et les épaisseurs relatives des couches entre elles ne sont pas nécessairement respectées sur les figures.

### DESCRIPTION DETAILLEE DE L'INVENTION

La présente invention concerne un procédé de fabrication d'un substrat support 10 en carbure de silicium poly-cristallin (p-SiC).

Le procédé comprend en premier lieu une étape a) de croissance d'un substrat initial 1 en carbure de silicium poly-cristallin sur un germe 2 en graphite ou en carbure de silicium monocristallin ou poly-cristallin de faible qualité (figure 1a). Le germe 2 se présente préférentiellement sous la forme d'une plaquette dont le diamètre est sensiblement celui qui est visé pour le substrat support 10, par exemple 100mm, 150mm, 200mm voire 300mm.

La croissance du substrat initial 1 en p-SiC est opérée par une technique connue de dépôt chimique en phase vapeur (CVD), à une température typiquement comprise entre 1100°C et 1500°C. Les précurseurs peuvent être choisis parmi le methylsilane, le diméthyldichlorosilane ou encore le dichlorosilane et i-butane, préférentiellement avec un rapport C/Si proche ou supérieur à 1. Optionnellement, des espèces dopantes (telles que l'azote ou le phosphore, par exemple) pourront être introduites au cours du dépôt CVD, de manière à ajuster la résistivité du substrat initial 1 (dont sera issu le substrat support 10) aux spécifications du produit final, en particulier de la structure composite visée. Les niveaux de dopage habituellement visés sont supérieurs à 1E18/cm³, voire supérieurs à 1E20/cm³.

A l'issue de l'étape a), le substrat initial 1 présente une face avant 1a libre et une face arrière 1b en contact avec le germe 2. L'épaisseur du substrat initial 1 est inférieure à 1mm, préférentiellement inférieure à 550µm. Notons que la gamme d'épaisseurs habituellement souhaitée, pour un substrat support 10 destiné à l'élaboration d'une structure composite, est 100µm - 500µm.

Le substrat initial 1 peut comporter des grains de carbure de silicium de type 4H, 6H et/ou 3C, selon les conditions de dépôt CVD.

La taille moyenne des grains au niveau de la face arrière 1b du substrat initial 1 est relativement faible, typiquement inférieure ou égale à 1µm, voire inférieure ou égale à 100nm ; lesdits grains correspondent au matériau p-SiC élaboré en début de dépôt CVD (phase de nucléation) sur le germe de graphite 2.

Rappelons que la taille d'un grain, délimité par les joints de grains, correspond à la plus grande dimension dudit grain, dans le plan de la face considérée du substrat. On définit la taille moyenne des grains par la moyenne des tailles des différents grains dans ledit plan. Pour mesurer les dimensions des grains ou distances entre joints de grain, il est possible de se baser sur des images obtenues par microscopie électronique à balayage (MEB) classique ou impliquant une diffraction électronique (EBSD « Electron Back Scattered Diffraction »). Il est également envisageable d'utiliser des cristallographies par rayons X. Lorsque la face considérée comprend majoritairement des grains de taille micrométrique (typiquement de quelques microns à quelques dizaines de microns), les grains de très petite taille, typiquement inférieure à 50nm, sont préférentiellement exclus de la mesure, pour limiter les incertitudes de mesure.

Au fur et à mesure du dépôt CVD, les grains de p-SiC augmentent en taille, jusqu'à atteindre une taille moyenne relativement stable, pour une épaisseur de dépôt qui peut varier entre quelques micromètres et quelques dizaines de micromètres, selon les conditions de dépôt.

Ainsi, selon l'épaisseur déposée de p-SiC pour croitre le substrat initial 1, la taille moyenne des grains au niveau de la face avant dudit substrat 1 pourra typiquement varier entre 1 et 10 µm.

Par la suite, la taille moyenne des grains p-SiC au niveau de la face avant 1a du substrat initial 1 sera appelée première taille moyenne, et la taille moyenne des grains de p-SiC au niveau de la face arrière 1b du substrat initial 1 sera appelée deuxième taille moyenne.

La première taille moyenne des grains p-SiC (côté face avant 1a) est supérieure à la deuxième taille moyenne des grains (côté face arrière 1b), cette dernière correspondant à la phase de nucléation.

Le procédé de fabrication comprend ensuite une étape b) de formation d'un film raidisseur 3 en carbone, sur la face avant 1a du substrat initial 1 (figure 1b). Le film raidisseur 3 peut présenter une épaisseur allant de 100nm à plusieurs millimètres, par exemple 10mm. Préférentiellement, son épaisseur est comprise entre 100nm et 10µm.

Avantageusement, le film raidisseur 3 en carbone présente une structure cristallographique de type diamant, c'est-à-dire comportant des liaisons atomiques carbone-carbone sp3, ou de type carbone vitreux, comportant des liaisons atomiques carbone-carbone sp2.

Le film raidisseur 3 peut être formé par différentes techniques de dépôt classiques, comme notamment un dépôt par plasma, un dépôt par bombardement d'ions ou encore un dépôt par évaporation.

Alternativement, l'étape b) peut être réalisée par étalement d'une résine polymère comportant des liaisons carbone-carbone préformées dans les trois dimensions, sous forme de couche visqueuse, sur la face avant 1a du substrat initial 1. Cet étalement peut être effectué par centrifugation. Puis, un recuit est appliqué à une température comprise entre 500°C et 2000°C, typiquement entre 600°C et 1100°C, sous azote, pour former le film raidisseur 3 en carbone, par décomposition chimique de la résine (pyrolyse). Les rampes en température sont typiquement choisies de l'ordre de 10°C/min et la durée du recuit est de l'ordre de l'heure. La montée en températures est contrôlée de sorte que la température effective demeure inférieure à la température de transition vitreuse résine/carbone.

La résine polymère peut être formée de goudron de houille, de phénol formaldéhyde, d'alcool polyfurfurylique, d'alcool polyvinylique, de polyacrylonitrile, de chlorure de polyvinylidène, et/ou de polystyrène, etc.

A titre d'exemple, des résines photosensibles connues peuvent être utilisées, telles que les produits commerciaux AZ-4330, AZ-P4620 (marques déposées) (à base de 1-methoxy-2-propanol acetate, esters diazonaphthoquinonesulfonic, 2-methoxy-1-propanol acetate, résine Cresol novolak), OCG-825 (à base d'ethyl-3-ethoxypropionate), SU-8 2000 (à base de cyclopentanone, sels triarylsulfonium/hexafluoroantimonate, propylene carbonate, résine epoxy), habituellement mis en œuvre pour des étapes de photolithographie dans le domaine de la microélectronique.

Des résines époxy, telles que par exemple le produit Epoxy Novolac EPON (marque déposée), proposé pour recouvrir et protéger différentes surfaces dans des domaines variés (aéronautique, marine, automobile, construction...), peuvent également être mises en œuvre à l'étape b) du procédé selon l'invention.

Dans le cas d'utilisation de résines, il est important de tenir compte de la contraction que la couche visqueuse de résine va subir lors du recuit, pour définir son épaisseur initiale suffisante en vue de l'obtention de l'épaisseur de film raidisseur 3 visée. La contraction en épaisseur peut être typiquement entre 70% et 95%. Le ratio carbone, c'est-à-dire le ratio entre la masse de la couche de résine polymère après pyrolyse (correspondant au film raidisseur 3) et la masse initiale de la couche de résine polymère étalée, doit être d'au moins 5%, préférentiellement supérieur à 50%.

Optionnellement, le procédé de fabrication peut comprendre une étape a'), entre l'étape a) et l'étape b), de rectification de la face avant 1a et/ou d'un pourtour 1c du substrat initial 1, pour diminuer une rugosité de surface de ladite face 1a et/ou diminuer une variation d'épaisseur dudit substrat 1, et/ou pour régulariser le pourtour 1c.

L'étape a') peut comprendre un amincissement mécanique ou mécano-chimique (polissage), avec un enlèvement de matière de l'ordre de quelques microns à quelques dizaines de microns.

Le procédé de fabrication selon l'invention comprend ensuite une étape c) de retrait du germe 2, de manière à libérer la face arrière 1b du substrat initial 1 (figure 1c).

Lorsque le germe 2 est en graphite, le retrait peut être effectué en brulant le graphite, en appliquant un traitement thermique, sous atmosphère riche en oxygène (l'air, par exemple), à une température supérieure à 400°C, préférentiellement supérieure à 550°C.

Il est également envisageable de détacher mécaniquement le germe 2, qu'il soit en graphite ou en carbure de silicium, par exemple par application localisée d'une contrainte mécanique, à ou proche de l'interface entre le germe 3 et le substrat initial 1.

Si d'éventuels résidus subsistent sur la face arrière 1b du substrat initial 1 après retrait du germe 2, ils peuvent être brulés (lorsqu'ils sont en graphite) ou retirés mécaniquement ou chimiquement par polissage ou gravure (lorsqu'ils sont en graphite ou en SiC).

Ce retrait génère classiquement une forte courbure du substrat initial 1, pouvant aller jusqu'à 500µm pour un diamètre de 150mm. Cette courbure est principalement due aux contraintes associées à la différence de tailles de grains entre la deuxième face 1b (grains de nucléation, de taille moyenne faible) et la première face 1a.

Dans le cadre de l'invention, le film raidisseur 3 en carbone permet de limiter grandement l'augmentation de courbure lors du retrait du germe 2, en maintenant mécaniquement le substrat initial 1 par sa face avant 1a. La courbure du substrat initial 1, muni du film raidisseur 3 en carbone, n'excède pas 200µm pour un diamètre de substrat de 150 mm ; voire même, la courbure est maintenue inférieure à 100µm. Dans ces gammes de courbure, le substrat initial 1 peut être traité sans problème dans des lignes et des équipements standard, sans risque de casse ou de mise en défaut des équipements ; ces problématiques sont essentiellement rencontrées pour des courbures supérieures à 300µm (diamètre 150 mm) .

Le procédé de fabrication comprend enfin une étape d) d'amincissement de la face arrière 1b du substrat initial 1. Le substrat initial 1 aminci forme le substrat support 10 (figure 1d).

L'amincissement de l'étape d) est réalisé par rectification mécanique, polissage mécanique et/ou polissage mécano-chimique de la face arrière 1b. L'enlèvement de matière est typiquement compris entre quelques dizaines de microns et 200µm, en fonction de l'épaisseur du substrat initial 1 à l'entrée de l'étape d), et bien sûr en fonction de l'épaisseur visée pour le substrat support 10.

L'amincissement est opéré jusqu'à une épaisseur pour laquelle le substrat initial 1 présente, dans le plan de sa face arrière amincie 1b', une troisième taille moyenne de grains égale à la première taille moyenne de grains à +/- 30% près. Autrement dit, si la première taille moyenne est par exemple de 5µm, la troisième taille moyenne est attendue entre 4µm et 6µm.

Il peut arriver que les tailles de grains dans le plan de la face avant 1a ou dans le plan de la face arrière 1b se répartissent selon une double population, chaque pic suivant une distribution sensiblement gaussienne. Selon une première option, la taille moyenne de grains est calculée en effectuant la moyenne globale incluant les deux populations, et les première et troisième tailles moyennes ne doivent pas différer de plus de 30%. Selon une deuxième option, on prendra en considération les deux premières tailles moyennes (correspondant à la double population du côté de la face avant 1a) et les deux troisièmes tailles moyennes (correspondant à la double population du côté de la face arrière 1b), qui ne devront pas différer respectivement entre elles de plus de 30%.

Après l'amincissement de l'étape d), la face arrière amincie 1b' du substrat initial 1 présente une taille moyenne de grains en p-SiC différant de moins de 30% de la taille moyenne de grains de la face avant 1a. La contrainte résiduelle dans le substrat initial 1 aminci (qui forme le substrat support 10) est alors compatible avec une courbure faible, et tout le moins gérable dans les lignes de fabrication.

Le procédé de fabrication peut alors comprendre une étape e) de retrait du film raidisseur 3, par exemple par gravure chimique sèche ou humide (figure 1e). Après ce retrait, le substrat support 10 présente une courbure inférieure à 200µm, voire inférieure à 100µm (pour un diamètre de 150 mm), du fait de la contrainte résiduelle réduite dans son volume.

A ce stade, le substrat support 10 présente une première face 10a, une deuxième face 10b et un bord 10c, correspondant respectivement à la face avant 1a, à la face arrière amincie 1b' et au bord 1c du substrat initial 1 après l'étape d).

A titre d'exemple, pour former un substrat support de 350µm d'épaisseur et de diamètre 150mm, on peut élaborer un substrat initial 1 de 500µm sur le germe 2, le substrat initial 1 présentant une première taille moyenne de grains de p-SiC au niveau de sa face avant 1a de l'ordre de 4µm. Une étape de correction de l'uniformité de l'épaisseur du substrat initial 1 peut être réalisée, par exemple via un enlèvement de 50µm. Un film raidisseur 3 en carbone de 4µm est formé sur cette face avant 1a. Après le retrait du germe de graphite 2, la deuxième taille moyenne de grains au niveau de la face arrière 1b du substrat initial 1 est inférieure à 100nm ; mais la courbure du substrat initial 1, du fait de la présence du film raidisseur 3, est maintenue inférieure à 150µm. Un enlèvement de 100µm au niveau de sa face arrière 1b est opéré, et la troisième taille moyenne de grains de p-SiC au niveau de la face arrière amincie 1b', de l'ordre de 3µm, respecte la condition d'égalité à 30% près vis-à-vis de la première taille moyenne de grains. Ainsi, après retrait du film raidisseur 3, la courbure du substrat support 10 est inférieure à 200µm et compatible avec des étapes ultérieures de fabrication d'une structure composite 100.

Optionnellement, après l'étape e), un traitement de surface peut être appliqué à la première face 10a du substrat support 10, en particulier si cette face 10a est destinée à recevoir la couche mince 20 de la structure composite 100, à une étape f) ultérieure du procédé. Ce traitement de surface peut comprendre une rectification mécanique, un polissage mécano-chimique ou autres nettoyages chimiques, en fonction de la rugosité de surface de la première face 10a.

Si la deuxième face 10b du substrat support 10 est destinée à recevoir la couche mince 20, et que l'étape d) n'a pas permis d'atteindre un niveau de rugosité suffisamment faible (typiquement < 1nm RMS, mesurée par microscopie à force atomique sur des scans de 20µmx20µm), un traitement de surface additionnel pourra également lui être appliqué.

La face du substrat support 10 destinée à former la face arrière de la structure composite 100 peut présenter une rugosité de surface plus importante, par exemple de l'ordre de 10nm RMS.

Le procédé de fabrication peut également comprendre un traitement thermique, après l'étape d) ou après l'étape e), à une température supérieure ou égale à 1500°C, typiquement entre 1500°C et 1900°C, de manière à stabiliser la structure poly-cristalline du substrat support 10. En effet, ces gammes de températures sont susceptibles d'être appliquées plus tard dans le procédé, notamment pour la fabrication d'une structure composite.

Grâce au procédé de fabrication selon la présente invention, un substrat support 10, présentant des caractéristiques mécaniques compatibles avec les spécifications d'une structure composite pour applications microélectroniques, peut être obtenu de manière simple, sans nécessiter le dépôt d'un substrat initial p-SiC de très forte épaisseur, laquelle est à plus de 80% éliminée, pour sélectionner une infime portion utile de p-SiC, comme cela est pratiqué dans les procédés de l'état de l'art. Dans le procédé de fabrication selon l'invention, l'épaisseur de substrat initial 1 formé est inférieure ou égale à 1mm et l'enlèvement de matière au niveau de sa face avant 1a et/ou de sa face arrière 1b est inférieur à 70%, voire inférieur à 50% de l'épaisseur initiale, ce qui procure une économie de matière et d'étapes technologiques.

Dans le cadre de l'élaboration d'une structure composite 100, le procédé de fabrication selon l'invention peut se poursuivre par une étape f) de transfert d'une couche utile 20 en carbure de silicium monocristallin sur le substrat support 10, basée sur un collage par adhésion moléculaire (figure 1f).

Il existe différentes options, connues de l'état de la technique pour effectuer un transfert de couche, qui ne seront pas décrites ici de manière exhaustive.

Selon un mode préféré, l'étape f) du procédé implique une implantation d'espèces légères selon le principe du procédé Smart Cut^{®}.

Dans une première phase f1), un substrat donneur 21 en carbure de silicium monocristallin, dont sera issue la couche utile 20, est fourni (figure 2a). Le substrat donneur 1 se présente préférentiellement sous la forme d'une plaquette de diamètre 100mm, 150mm, 200mm voire 300mm (identique à ou très proche de celui du substrat support 10) et d'épaisseur comprise typiquement entre 300µm et 800µm. Il présente une face avant 21a et une face arrière 21b. La rugosité de surface de la face avant 1a est avantageusement choisie inférieure à 1nm RMS, voire inférieure à 0,5nm RMS, mesurée par microscopie à force atomique (AFM) sur un scan de 20µm x 20µm. Le substrat donneur 21 peut être de polytype 4H ou 6H, et présenter un dopage de type n ou p, en fonction des besoins des composants qui seront élaborés sur et/ou dans la couche utile 20 de la structure composite 100.

Une deuxième phase f2) correspond à l'introduction d'espèces légères dans le substrat donneur 21 pour former un plan fragile enterré 22 délimitant, avec une face avant 21a du substrat donneur 21, la couche utile 20 à transférer (figure 2b).

Les espèces légères sont préférentiellement de l'hydrogène, de l'hélium ou une co-implantation de ces deux espèces, et sont implantées à une profondeur déterminée dans le substrat donneur 21, cohérente avec l'épaisseur de la couche utile 20 visée. Ces espèces légères vont former, autour de la profondeur déterminée, des microcavités distribuées dans une fine couche parallèle à la surface libre 21a du substrat donneur 21, soit parallèle au plan (x,y) sur les figures. On appelle cette fine couche le plan fragile enterré 22, par souci de simplification.

L'énergie d'implantation des espèces légères est choisie de manière à atteindre la profondeur déterminée. Par exemple, des ions hydrogène seront implantés à une énergie comprise entre 10 keV et 250 keV, et à une dose comprise entre 5^{E}16/cm² et 1^{E}17/cm², pour délimiter une couche utile 20 présentant une épaisseur de l'ordre de 100nm à 1500nm. Notons qu'une couche de protection pourra être déposée sur la face avant 21a du substrat donneur 21, préalablement à l'étape d'implantation ionique. Cette couche de protection peut être composée par un matériau tel que l'oxyde de silicium ou le nitrure de silicium par exemple. Elle est retirée préalablement à la phase suivante.

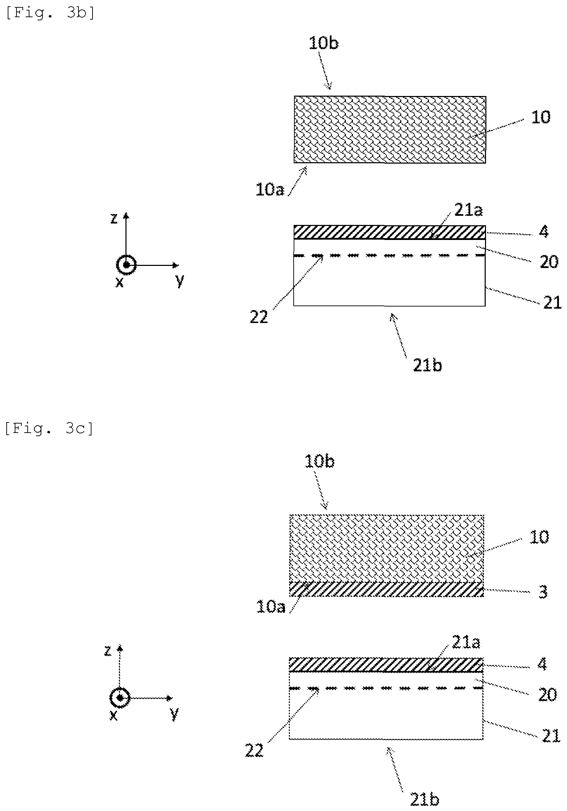

Optionnellement, une couche intermédiaire 4 peut être formée sur la face avant 21a du substrat donneur 21, avant ou après la deuxième phase f2) d'introduction des espèces légères (figures 3b, 3c, 3d, 3e). Cette couche intermédiaire 4 peut être en un matériau semi-conducteur, par exemple silicium ou carbure de silicium, ou en un matériau métallique tel que le tungstène, le titane, etc. L'épaisseur de la couche intermédiaire 4 est avantageusement limitée, typiquement entre quelques nanomètres et quelques dizaines de nanomètres.

Dans le cas où la couche intermédiaire 4 est formée avant la phase f2), l'énergie d'implantation (et potentiellement la dose) des espèces légères sera ajustée à la traversée de cette couche supplémentaire. Dans le cas où la couche intermédiaire 4 est formée après la phase f2), on prendra soin de former cette couche en appliquant un budget thermique inférieur au budget thermique de bullage, ledit budget thermique de bullage correspondant à l'apparition de cloques à la surface du substrat donneur 21 du fait d'une croissance et d'une mise sous pression trop importante des microcavités dans le plan fragile enterré 22.

L'étape f) de transfert comprend ensuite une troisième phase f3) d'assemblage du substrat donneur 21, du côté de sa face avant 21a, sur le substrat support 10, du côté de sa première face 10a ou de sa deuxième face 10b, par collage par adhésion moléculaire, le long d'une interface de collage 30 (figure 2c).

De manière optionnelle, une couche intermédiaire 4' peut également être déposée sur la face à assembler du substrat support 10, préalablement à la phase f3) d'assemblage (figures 3d, 3e) ; elle peut être choisie de même nature ou de nature différente de la couche intermédiaire 4 évoquée pour le substrat donneur 21. Une couche intermédiaire 4,4' peut éventuellement n'être déposée que sur l'un ou l'autre des deux substrats 21,10 à assembler.

L'objectif de la (ou des) couche(s) intermédiaire(s) est essentiellement de favoriser l'énergie de collage (notamment dans la gamme de températures inférieures à 1100°C), du fait de la formation de liaisons covalentes à plus basses températures que dans le cas de deux surfaces SiC assemblées directement ; un autre avantage de cette(ces) couche(s) intermédiaire(s) peut être d'améliorer la conduction électrique verticale de l'interface de collage 30.

Selon une variante envisageable, la couche intermédiaire peut être formée par le film raidisseur 3 en carbone, conservé sur la première face 10a du substrat support 10 (figures 3a, 3c). Dans ce cas, l'étape e) du procédé de fabrication selon l'invention n'est pas réalisée et la face à assembler du substrat support 10 est sa première face 10a munie du film 3. Pour favoriser la conduction électrique verticale à travers le film raidisseur 3, dans la structure composite 100 finale, on privilégiera un film en carbone avec une structure cristallographique de type diamant.

De manière optionnelle, un film additionnel 5 en carbone est disposé sur la face opposée à la face à assembler du substrat support 10, toujours préalablement à la phase f3) d'assemblage (figure 3e). Ses caractéristiques peuvent par exemple être choisies parmi celles proposées pour le film raidisseur 3 précédemment dans cette description.

Même si la présence de ce film additionnel 5 a été illustré sur la figure 3e en combinaison de couches intermédiaires 4,4' sur les faces à assembler respectivement du substrat donneur 21 et du substrat support 10, ce film additionnel 5 peut être mis en œuvre dans l'une quelconque des configurations possibles évoquées, notamment celles illustrées sur les figures 3a à 3c. Le film additionnel 5 pourra être retiré ultérieurement, préférentiellement après que la structure composite 100 ait subi tous traitements thermiques à températures supérieures à 1400°C requis pour sa fabrication ou celle de composants sur et/ou dans ladite structure 100.

Revenant à la description de la phase f3) d'assemblage, et comme cela est bien connu en soi, le collage direct par adhésion moléculaire ne nécessite pas une matière adhésive, car des liaisons s'établissent à l'échelle atomique entre les surfaces assemblées. Plusieurs types de collage par adhésion moléculaire existent, qui diffèrent notamment par leurs conditions de température, de pression, d'atmosphère ou de traitements préalables à la mise en contact des surfaces. On peut citer le collage à température ambiante avec ou sans activation préalable par plasma des surfaces à assembler, le collage par diffusion atomique (« Atomic diffusion bonding » ou ADB selon la terminologie anglo-saxonne), le collage avec activation de surface (« Surface-activated bonding » ou SAB), etc.

La phase f3) d'assemblage peut comprendre, préalablement à la mise en contact des faces 21a,10a à assembler, des séquences classiques de nettoyages par voie chimique (par exemple, nettoyage RCA), d'activation de surface (par exemple, par plasma oxygène ou azote) ou autres préparations de surface (telles que le nettoyage par brossage (« scrubbing »)), susceptibles de favoriser la qualité de l'interface de collage 30 (faible défectivité, forte énergie d'adhésion).

Enfin, une quatrième phase f4) comprend la séparation le long du plan fragile enterré 22, qui mène au report de la couche utile 20 sur le substrat support 10 (figure 2d).

La séparation le long du plan fragile enterré 22 s'opère habituellement par l'application d'un traitement thermique à une température comprise entre 800°C et 1200°C. Un tel traitement thermique induit le développement des cavités et microfissures dans le plan fragile enterré 22, et leur mise sous pression par les espèces légères présentes sous forme gazeuse, jusqu'à la propagation d'une fracture le long dudit plan fragile 22. Alternativement ou conjointement, une sollicitation mécanique peut être appliquée à l'ensemble collé et en particulier au niveau du plan fragile enterré 22, de manière à propager ou aider à propager mécaniquement la fracture menant à la séparation. A l'issue de cette séparation, on obtient d'une part la structure semi-conductrice 100 comprenant le substrat support 10 et la couche utile 20 transférée en SiC monocristallin, et d'autre part, le reste 21' du substrat donneur. Le niveau et le type de dopage de la couche utile 20 sont définis par le choix des propriétés du substrat donneur 21 ou peuvent être ajustés ultérieurement via les techniques connues de dopage de couches semi-conductrices.

La surface libre 20a de la couche utile 20 est habituellement rugueuse après séparation : par exemple, elle présente une rugosité comprise entre 5nm et 100nm RMS (AFM, scan 20µm x 20µm). Des phases de nettoyage et/ou de lissage peuvent être appliquées pour restaurer un bon état de surface (typiquement, une rugosité inférieure à quelques angströms RMS sur un scan de 20µm x 20µm par AFM). En particulier, ces phases peuvent comprendre un traitement de lissage mécano-chimique de la surface libre de la couche utile 20. Un enlèvement compris entre 50nm et 300nm permet de restaurer efficacement l'état de surface de ladite couche 20. Elles peuvent également comprendre au moins un traitement thermique à une température comprise entre 1300°C et 1800°C. Un tel traitement thermique est appliqué pour évacuer les espèces légères résiduelles de la couche utile 20 et pour favoriser le réarrangement du réseau cristallin de la couche utile 20. Il permet en outre de renforcer l'interface de collage 30.

Le traitement thermique peut également comprendre ou correspondre à une épitaxie de carbure de silicium sur la couche mince 20.

Enfin, notons que l'étape f) de transfert peut comprendre une étape de reconditionnement du reste 21' du substrat donneur en vue d'une réutilisation en tant que substrat donneur 21 pour une nouvelle structure composite 100. Des traitements mécaniques et/ou chimiques, similaires à ceux appliqués à la structure composite 100, peuvent être mis en œuvre au niveau de la face avant 21'a du substrat restant 21'.

La structure composite 100 obtenue est extrêmement robuste aux traitements thermiques à très hautes températures susceptibles d'être appliqués pour améliorer la qualité de la couche utile 20 ou pour fabriquer des composants sur et/ou dans ladite couche 20.

La structure composite 100 selon l'invention est particulièrement adaptée pour l'élaboration d'un (ou plusieurs) composant(s) microélectronique(s) à haute tension, tels que par exemple des diodes Schottky, des transistors MOSFET, etc. Elle répond plus généralement aux applications microélectroniques de puissance, en autorisant une excellente conduction électrique verticale, une bonne conductibilité thermique et en procurant une couche utile en c-SiC de haute qualité.

Bien entendu, l'invention n'est pas limitée aux modes de réalisation et aux exemples décrits, et on peut y apporter des variantes de réalisation sans sortir du cadre de l'invention tel que défini par les revendications.

## Revendications

1. Procédé de fabrication d'un substrat support (10) en carbure de silicium poly-cristallin comprenant les étapes suivantes :
a) la croissance d'un substrat initial (1) en carbure de silicium poly-cristallin sur un germe (2) en graphite ou en carbure de silicium ; à l'issue de l'étape a), le substrat initial (1) présentant une face avant (1a) libre et une face arrière (1b) en contact avec le germe (2),
b) la formation d'un film raidisseur (3) en carbone, sur la face avant (1a) du substrat initial (1), le substrat initial (1) présentant, dans le plan de sa face avant (1a) et juste avant la formation du film raidisseur (3), une première taille moyenne de grains de carbure de silicium,
c) le retrait du germe (2), de manière à libérer la face arrière (1b) du substrat initial (1), ce dernier présentant, dans le plan de sa face arrière (1b) et juste après le retrait du germe (2), une deuxième taille moyenne de grains de carbure de silicium, inférieure à la première taille moyenne,
d) l'amincissement de la face arrière (1b) du substrat initial (1), jusqu'à une épaisseur pour laquelle le substrat initial (1) présente, dans le plan de sa face arrière amincie (1b'), une troisième taille moyenne de grains égale à la première taille moyenne de grains à +/- 30% près, le substrat initial (1) aminci formant le substrat support (10).

2. Procédé de fabrication selon la revendication précédente, dans lequel le film raidisseur (3) présente une épaisseur comprise entre 100nm et plusieurs millimètres, par exemple 10mm.

3. Procédé de fabrication selon la revendication précédente, dans lequel le film raidisseur (3) présente une épaisseur comprise entre 100nm et 10µm.

4. Procédé de fabrication selon l'une des revendications précédentes, dans lequel le film raidisseur (3) en carbone présente une structure cristallographique de type diamant ou de type carbone vitreux.

5. Procédé de fabrication selon l'une des revendications précédentes, dans lequel l'étape b) est réalisée par étalement d'une résine polymère comportant des liaisons carbone-carbone préformées dans les trois dimensions, sous forme de couche visqueuse, sur la face avant du substrat initial (1), et par recuit à une température comprise entre 500°C et 2000°C, pour former le film raidisseur (3) en carbone.

6. Procédé de fabrication selon la revendication précédente, dans lequel la résine polymère est à base de goudron de houille, de phénol formaldéhyde, d'alcool polyfurfurylique, d'alcool polyvinylique, de polyacrylonitrile, de chlorure de polyvinylidène, et/ou de polystyrène.

7. Procédé de fabrication selon l'une des revendications 1 à 4, dans lequel l'étape b) est réalisée par dépôt par plasma, dépôt par bombardement d'ions ou dépôt par évaporation.

8. Procédé de fabrication selon l'une des revendications précédentes, comprenant une étape a'), entre l'étape a) et l'étape b), de rectification de la face avant (1a) et/ou d'un pourtour du substrat initial (1), pour diminuer une rugosité de surface de ladite face (1a) et/ou une variation d'épaisseur dudit substrat (1), et/ou pour régulariser son pourtour.

9. Procédé de fabrication selon la revendication précédente, dans lequel l'étape a') comprend un amincissement mécanique ou mécano-chimique.

10. Procédé de fabrication selon l'une des revendications précédentes, comprenant :
- une étape e), après l'étape d), de retrait du film raidisseur, et/ou
- une étape, après l'étape d) ou après l'étape e), de traitement thermique à une température supérieure ou égale à 1500°C.

11. Procédé de fabrication d'une structure composite (100), mettant en œuvre le procédé selon l'une des revendications précédentes et comprenant en outre une étape f) de transfert d'une couche mince (20) en carbure de silicium monocristallin sur une première (10a) ou sur une deuxième (10b) face du substrat support (10), directement ou via une couche intermédiaire, pour former la structure composite (100).

12. Procédé de fabrication selon la revendication précédente, dans lequel la couche intermédiaire est formée par le film raidisseur (3) en carbone conservé sur la première face (10a) du substrat support (10).

13. Procédé de fabrication selon la revendication 11, dans lequel le transfert de la couche mince (20) est réalisé sur l'une des faces (10a ;10b) du substrat support (10) et un film additionnel (5) en carbone est disposé sur l'autre face libre (10b ;10a) du substrat support (10) préalablement au transfert.

14. Procédé de fabrication selon la revendication précédente, dans lequel le film additionnel (5) est retiré, préférentiellement après que la structure composite (100) ait subi tous traitements thermiques à températures supérieures à 1400°C requis pour sa fabrication ou celle de composants sur et/ou dans ladite structure (100).

## Patentansprüche

1. Verfahren zum Herstellen eines Trägersubstrats (10) aus polykristallinem Siliziumkarbid, umfassend die folgenden Schritte:
a) Züchten eines Ausgangssubstrats (1) aus polykristallinem Siliziumkarbid auf einem Keim (2) aus Graphit oder aus Siliziumkarbid, wobei am Ende von Schritt a) das Ausgangssubstrat (1) eine freie Vorderseite (1a) und eine Rückseite (1b) aufweist, die mit dem Keim (2) in Kontakt steht,
b) Ausbilden einer Versteifungsfolie (3) aus Kohlenstoff auf der Vorderseite (1a) des Ausgangssubstrats (1), wobei das Ausgangssubstrat (1) in der Ebene seiner Vorderseite (1a) und unmittelbar vor dem Ausbilden der Versteifungsfolie (3) eine erste Durchschnittsgröße von Siliziumkarbidkörnern aufweist,
c) Entfernen des Keims (2), um die Rückseite (1b) des Ausgangssubstrats (1) freizugeben, wobei letzteres in der Ebene seiner Rückseite (1b) und unmittelbar nach dem Entfernen des Keims (2) eine zweite Durchschnittsgröße von Siliziumkarbidkörnern aufweist, die kleiner als die erste Durchschnittsgröße ist,
d) Ausdünnen der Rückseite (1b) des Ausgangssubstrats (1) auf eine Dicke, bei der das Ausgangssubstrat (1) in der Ebene seiner ausgedünnten Rückseite (1b') eine dritte Durchschnittskorngröße aufweist, die gleich einer Abweichung von innerhalb +/- 30 % der ersten durchschnittlichen Korngröße ist, wobei das ausgedünnte Ausgangssubstrat (1) das Trägersubstrat (10) ausbildet.

2. Herstellungsverfahren nach dem vorstehenden Anspruch, wobei die Versteifungsfolie (3) eine Dicke zwischen 100 nm und mehreren Millimetern, beispielsweise 10 mm, aufweist.

3. Herstellungsverfahren nach dem vorstehenden Anspruch, wobei die Versteifungsfolie (3) eine Dicke zwischen 100 nm und 10 µm aufweist.

4. Herstellungsverfahren nach einem der vorstehenden Ansprüche, wobei die Versteifungsfolie (3) aus Kohlenstoff eine kristallographische Struktur vom Diamanttyp oder vom Glaskohlenstofftyp aufweist.

5. Herstellungsverfahren nach einem der vorstehenden Ansprüche, wobei Schritt b) durch Aufbringen eines Polymerharzes, das dreidimensional vorgeformte Kohlenstoff-Kohlenstoff-Bindungen vorweist, in Form einer viskosen Schicht auf die Vorderseite des Ausgangssubstrats (1) und durch anschließendes Tempern bei einer Temperatur zwischen 500 °C und 2000 °C zum Ausbilden der Versteifungsfolie (3) aus Kohlenstoff durchgeführt wird.

6. Herstellungsverfahren nach dem vorstehenden Anspruch, wobei das Polymerharz auf Basis von Kohlenteer, Phenolformaldehyd, Polyfurfurylalkohol, Polyvinylalkohol, Polyacrylnitril, Polyvinylidenchlorid und/oder Polystyrol ist.

7. Herstellungsverfahren nach einem der Ansprüche 1 bis 4, wobei Schritt b) durch Plasmaabscheidung, lonenbeschussabscheidung oder Aufdampfung durchgeführt wird.

8. Herstellungsverfahren nach einem der vorstehenden Ansprüche, umfassend einen Schritt a'), zwischen Schritt a) und Schritt b), zum Schleifen der Vorderseite (1a) und/oder eines Umfangs des Ausgangssubstrats (1) zum Verringern einer Oberflächenrauheit der Vorderseite (1a) und/oder einer Dickenvariation des Substrats (1) und/oder zum Regulieren seines Umfangs.

9. Herstellungsverfahren nach dem vorstehenden Anspruch, wobei der Schritt a') ein mechanisches oder mechanisch-chemisches Ausdünnen umfasst.

10. Herstellungsverfahren nach einem der vorstehenden Ansprüche, umfassend:
- einen Schritt e) nach Schritt d) zum Entfernen der Versteifungsfolie, und/oder
- einen Wärmebehandlungsschritt nach Schritt d) oder nach Schritt e) bei einer Temperatur von mindestens 1500 °C.

11. Verfahren zum Herstellen einer Verbundstruktur (100), das das Verfahren nach einem der vorstehenden Ansprüche implementiert und ferner einen Schritt f) zum Übertragen einer dünnen Schicht (20) aus monokristallinem Siliziumkarbid auf eine erste (10a) oder auf eine zweite (10b) Seite des Trägersubstrats (10), direkt oder über eine Zwischenschicht, zum Ausbilden der Verbundstruktur (100) umfasst.

12. Herstellungsverfahren nach dem vorstehenden Anspruch, wobei die Zwischenschicht durch die Versteifungsfolie (3) aus Kohlenstoff ausgebildet wird, der auf der ersten Seite (10a) des Trägersubstrats (10) befestigt ist.

13. Herstellungsverfahren nach Anspruch 11, wobei die Übertragung der dünnen Schicht (20) auf eine der Seiten (10a; 10b) des Trägersubstrats (10) durchgeführt wird und vor der Übertragung auf der anderen freien Seite (10b; 10a) des Trägersubstrats (10) eine zusätzliche Kohlenstofffolie (5) angeordnet wird.

14. Herstellungsverfahren nach dem vorstehenden Anspruch, wobei die zusätzliche Folie (5) entfernt wird, vorzugsweise nachdem die Verbundstruktur (100) alle Wärmebehandlungen bei Temperaturen über 1400 °C durchlaufen hat, die für ihre Herstellung oder diejenige von Komponenten auf und/oder in der Struktur (100) erforderlich sind.

## Claims

1. Method for producing a polycrystalline silicon carbide support substrate (10) comprising the following steps:
a) growing an initial substrate (1) consisting of polycrystalline silicon carbide on a seed (2) consisting of graphite or silicon carbide; at the end of step a), the initial substrate (1) having a free front face (1a) and a rear face (1b) in contact with the seed (2),
b) forming a stiffening film (3) made of carbon on the front face (1a) of the initial substrate (1), the initial substrate (1) having, in the plane of its front face (1a) and just prior to the formation of the stiffening film (3), a first average silicon carbide grain size,
c) removing the seed (2) so as to free the rear face (1b) of the initial substrate (1), the initial substrate having, in the plane of its rear face (1b) and just after removal of the seed (2), a second average silicon carbide grain size, smaller than the first average size,
d) thinning the rear face (1b) of the initial substrate (1) to a thickness at which the initial substrate (1) has, in the plane of its thinned rear face (1b'), a third average grain size equal to the first average grain size to within +/- 30%, the thinned initial substrate (1) forming the support substrate (10).

2. Production method according to the preceding claim, wherein the stiffening film (3) has a thickness of between 100 nm and several millimeters, for example 10 mm.

3. Production method according to the preceding claim, wherein the stiffening film (3) has a thickness of between 100 nm and 10 µm.

4. Production method according to any of the preceding claims, wherein the carbon stiffening film (3) has a diamond-type or glassy carbon-type crystallographic structure.

5. Production method according to any of the preceding claims, wherein step b) is carried out by spreading a polymer resin including three-dimensionally preformed carbon-carbon bonds, in the form of a viscous layer, on the front face of the initial substrate (1), and by annealing at a temperature of between 500°C and 2000°C, to form the carbon stiffening film (3).

6. Production method according to the preceding claim, wherein the polymer resin is made from coal tar, phenol formaldehyde, polyfurfuryl alcohol, polyvinyl alcohol, polyacrylonitrile, polyvinylidene chloride and/or polystyrene.

7. Production method according to any of claims 1 to 4, wherein step b) is carried out by plasma deposition, ion bombardment deposition or evaporation deposition.

8. Production method according to any of the preceding claims, comprising a step a'), between step a) and step b), of grinding the front face (1a) and/or a periphery of the initial substrate (1) to reduce a surface roughness of said face (1a) and/or a thickness variation of said substrate (1), and/or to regularize its periphery.

9. Production method according to the preceding claim, wherein step a') comprises mechanical or mechanochemical thinning.

10. Production method according to any of the preceding claims, comprising:
- a step e), after step d), of removing the stiffening film, and/or
- a step, after step d) or after step e), of heat treatment at a temperature greater than or equal to 1500°C.

11. Method for producing a composite structure (100), using the method according to any of the preceding claims and further comprising a step f) of transferring a thin layer (20) of monocrystalline silicon carbide onto a first (10a) or second (10b) face of the support substrate (10), directly or via an intermediate layer, to form the composite structure (100).

12. Production method according to the preceding claim, wherein the intermediate layer is formed by the carbon stiffening film (3) retained on the first face (10a) of the support substrate (10).

13. Production method according to claim 11, wherein the thin layer (20) is transferred onto one of the faces (10a; 10b) of the support substrate (10) and an additional carbon film (5) is arranged on the other free face (10b; 10a) of the support substrate (10) prior to the transfer.

14. Production method according to the preceding claim, wherein the additional film (5) is removed, preferably after the composite structure (100) has undergone all heat treatments at temperatures greater than 1400°C which are required for its production or that of components on and/or in said structure (100).
